# EUROPÄISCHE PATENTSCHRIFT

(11) **EP 1 800 360 B1**
(45) Veröffentlichungstag und Bekanntmachung des Hinweises auf die Patenterteilung: **22.02.2012**
(21) Anmeldenummer: 05800840.0
(22) Anmeldetag: 11.10.2005
(51) Int. Cl.: H01L 21/768, B82Y 10/00, C01B 31/02, H05K 1/00, H01L 51/40

(54) **ELEKTRISCHER SCHALTKREIS MIT EINER NANOSTRUKTUR UND VERFAHREN ZUM HERSTELLEN EINER KONTAKTIERUNG EINER NANOSTRUKTUR**
ELECTRICAL CIRCUIT WITH A NANOSTRUCTURE AND METHOD FOR CONTACTING A NANOSTRUCTURE
CIRCUIT ELECTRIQUE POURVU D'UNE NANOSTRUCTURE ET PROCEDE POUR FORMER UNE CONNEXION AVEC UNE NANOSTRUCTURE

(30) Priorität: 11.10.2004 DE 102004049453
(43) Veröffentlichungstag der Anmeldung: 27.06.2007
(73) Patentinhaber: Qimonda AG, 81739 München (DE)
(72) Erfinder: DÜSBERG, Georg, 01097 Dresden (DE); KREUPL, Franz, 80802 München (DE); SEIDEL, Robert, 01127 Dresden (DE); STEINLESBERGER, Gernot, 80804 München (DE)
(74) Vertreter: Viering, Jentschura & Partner
(86) Internationale Anmeldenummer: PCT/DE2005/001816
(87) Internationale Veröffentlichungsnummer: WO 2006/039907

(56) Entgegenhaltungen:
- WO-A-02/11216
- W. YU, J. ZHANG, X. LIU, W. XI: "Spinose carbon nanotubes grown on graphitized DLC film by low frequency r.f. plasma-enhanced chemical vapor deposition" DIAMOND AND RELATED MATERIALS, ELSEVIER SCIENCE PUBLISHERS, AMSTERDAM, NL, Bd. 12, Nr. 12, Dezember 2003 (2003-12), Seiten 2203-2207, XP004477150 ISSN: 0925-9635
- SUN X ET AL: "Growth of carbon nanotubes on carbon paper by Ohmically heating silane-dispersed catalytic sites" CHEMICAL PHYSICS LETTERS, NORTH-HOLLAND, AMSTERDAM, NL, Bd. 363, Nr. 5-6, 16. September 2002 (2002-09-16), Seiten 415-421, XP002247329 ISSN: 0009-2614
- NIHEI M ET AL: "SIMULTANEOUS FORMATION OF MULTIWALL CARBON NANOTUBES AND THEIR END-BONDED OHMIC CONTACTS TO TI ELECTRODES FOR FUTURE ULSI INTERCONNECTS" JAPANESE JOURNAL OF APPLIED PHYSICS, JAPAN SOCIETY OF APPLIED PHYSICS, TOKYO, JP, Bd. 43, Nr. 4B, April 2004 (2004-04), Seiten 1856-1859, XP001227691 ISSN: 0021-4922
- HUNG S C H ET AL: "GROWTH AND ANALYSIS OF POLYCRYSTALLINE CARBON FOR MOS APPLICATIONS" MATERIALS RESEARCH SOCIETY SYMPOSIUM PROCEEDINGS, MATERIALS RESEARCH SOCIETY, PITTSBURG, PA, US, Bd. 427, 1996, Seiten 317-322, XP009055951 ISSN: 0272-9172

## Beschreibung

Die Erfindung betrifft einen elektrischen Schaltkreis mit einer Nanostruktur und ein Verfahren zum Herstellen einer Kontaktierung einer Nanostruktur.

Die herkömmliche Silizium-Mikroelektronik wird bei weiter voranschreitender Verkleinerung an ihre Grenzen stoßen. Insbesondere die Entwicklung zunehmend kleinerer und dichter angeordneter Transistoren von mittlerweile mehreren hundert Millionen Transistoren pro Chip wird in den nächsten zehn Jahren prinzipiellen physikalischen Problemen und Begrenzungen ausgesetzt sein. Wenn Strukturabmessungen von ungefähr 80 nm unterschritten werden, werden die Bauelemente durch Quanteneffekte störend beeinflusst und unterhalb von Dimensionen von etwa 30 nm dominiert. Auch führt die zunehmende Integrätionsdichte der Bauelemente auf einem Chip zu einem dramatischen Anstieg der Abwärme.

Als mögliche Nachfolgetechnik der herkömmlichen Halbleiterelektronik sind Nanostrukturen wie beispielsweise Nanoröhren, insbesondere Kohlenstoff-Nanoröhren, und Nanostäbchen, auch Nanodrähte genannt, bekannt.

Eine Kohlenstoff-Nanoröhre ist eine einwandige oder mehrwandige, röhrenartige Kohlenstoffverbindung. Bei mehrwandigen Nanoröhren ist mindestens eine innere Nanoröhre von einer äußeren Nanoröhre koaxial umgeben. Einwandige Nanoröhren weisen typischerweise Durchmesser von 1 nm auf, die Länge einer Nanoröhre kann mehrere Hundert nm betragen. Die Enden einer Nanoröhre sind häufig mit jeweils einem halben Fulleren-Molekül abgeschlossen. Nanoröhren können hergestellt werden, indem auf einem Substrat eine Katalysatormaterial-Schicht, beispielsweise aus Eisen, Kobalt oder Nickel, abgeschieden wird und auf dieser Katalysatormaterial-Schicht unter Verwendung eines CVD-Verfahrens ("chemical vapour deposition") mittels Einleitens eines kohlenstoffhaltigen Materials (beispielsweise Azetylen) in die Verfahrenskammer Kohlenstoff-Nanoröhren auf der Katalysatormaterial-Schicht aufgewachsen werden. Aufgrund der guten elektrischen Leitfähigkeit von Kohlenstoff-Nanoröhren sowie aufgrund der Einstellbarkeit dieser Leitfähigkeit, beispielsweise mittels Anlegens eines externen elektrischen Feldes oder mittels Dotierens der Nanoröhren beispielsweise mit Kalium, eignen sich Nanoröhren für eine große Zahl von Anwendungen, insbesondere in der elektrischen Kopplungstechnik in integrierten Schaltkreisen, für Bauelemente in der Mikroelektronik sowie als Elektronenemitter.

Für viele integrierte Bauelemente in der Silizium-Mikroelektronik werden Feldeffekttransistoren benötigt. Zum Ausbilden eines solchen Feldeffekttransistors können Kohlenstoff-Nanoröhren verwendet werden, wodurch ein sogenannter CNT-FET ("carbon nanotube field effect transistor") gebildet wird [1], [2]. Hierfür wird beispielsweise eine Nanoröhre auf einer dielektrischen Schicht auf einem leitfähigen Substrat planar ausgebildet und kontaktiert. Die Leitfähigkeit der Kohlenstoff-Nanoröhre wird über eine geeignete an dem leitfähigen Substrat angelegte elektrische Spannung gesteuert, so dass der elektrische Stromfluss durch die Nanoröhre, anschaulich der elektrische Stromfluss zwischen den Source-/Drain-Anschlüssen des CNT-FETs, mittels Anlegens einer Spannung an das leitfähige Substrat steuerbar ist.

Ein Problem, das jedoch bei einem solchen CNT-FET auftreten kann, ist der relative hohe Kontaktwiderstand, welcher sich zwischen dem Kanalbereich des CNT-FET und den Source/Drainanschlüssen ausbildet und welcher zumindest teilweise durch das Ausbilden einer Schottky-Barriere erzeugt wird.

Das Ausbilden einer solchen Schottky-Barriere ist insbesondere in einem zweiten Anwendungsgebiet, in welchem CNTs eingesetzt werden können von Nachteil Hierbei werden CNTs als so genannte Vias oder Interconnects eingesetzt, d.h. als Verbindungsleitungen zwischen Leiterbahnen oder elektrischen Teil-Schaltkreisen, welche sich auf verschiedenen Ebenen eines elektrischen Schaltkreises befinden, oder als Vias in der so genannten 3D-Integration, d.h. einem geeigneten Übereinanderausbilden oder Übereinanderstapeln der einzelnen Komponenten oder Systemeinheiten des integrierten Schaltkreises. Hierdurch ist es möglich die Packungsdichte zu erhöhen und damit den Platz, welcher in einer Ebene benötigt wird, zu senken. Eine weitere Anwendung der 3D-Integration ist das Übereinanderstapeln von unterschiedlichen integrierten Schaltkreisen so genannter Systeme, welche auf einem gemeinsamen Chip integriert werden sollen, wodurch ein so genannter System-on-Chip (SoC) ausgebildet wird.

Um das Problem des hohen Kontaktwiderstands zu lösen werden verschiedene Metalle als Kontaktelektroden getestet, um den Kontaktwiderstand zu CNT's zu verringern. Beispielweise wurde bei Single Wall Carbon Nanotubes (SWCNT) mit großen Durchmesser so genannte transparente Kontakte, d.h. ohmsche Kontakte erzielt, indem die Kontakte mit Palladium hergestellt wurden [3], jedoch sind solche SWCNT's mit großen Durchmesser nur schlecht geeignet, um mit ihnen einen CNT-FET auszubilden. Weitere Möglichkeiten, den Kontaktwiderstand zu verringern, sind einerseits das Ausbilden von Carbiden mittels Carbidbildnern, beispielsweise Titan, und andererseits das Vergrößern der Kontaktfläche, wobei jedoch nur sehr wenige Materialien bekannt sind, welche als Carbidbildner fungieren können, bzw. eine Vergrößerung der Kontaktfläche dem in der Mikroelektronik vorhandenen Wunsch nach Verkleinerung aller Komponenten zuwiderläuft.

Dokument [4] beschreibt allgemeine Konzepte für die Integration von Kohlenstoff-Nanoröhren in der Mikroelektronik, unter anderem ein Konzept für die Herstellung von Kohlenstoff-Nanoröhren-Vias, wobei zum Kontaktieren der Kohlenstoff-Nanoröhren Nickel vorgeschlagen wird.

Dokument [5] beschreibt eine Gate-Elektrode bildende Kohlenstoffschicht eines ph-sensitiven Feldeffekttransistors.

Dokument [6] beschreibt einen Dünnfilmtransistor, bei dem ein Schwellenspannungs-steuemder Film zwischen einem Gate-isolierenden Film und einem organischen Halbleiter-Film bereitgestellt ist, so dass die Schwellenspannung auf einfache Weise gesteuert werden kann.

Dokument [7] beschreibt einen Film aus "stacheligen" Kohlenstoff-Nanoröhren, welche von nanomaßstäblichen Partikeln einer Eisen-Katalysatorschicht gewachsen sind.

Dokument [8] beschreibt einen Feldeffekttransistor mit einem Kanalbereich aus Kohlenstoff-Nanoröhren.

Dokument [9] beschreibt die Bildung von mehrwandigen Kohlenstoff-Nanoröhren, die mit Metall-Silizid-Schichten eine MOSFETs gekoppelt sind und/oder als Zwischenverbindungen von Multilayer-Kupferverdrahtungen in ULSI-Schaltungen dienen.

Dokument [10] zeigt, dass graphitisiertes Kohlenstoffmaterial ein Kandidat zur Anwendung bei Gates und lokalen Zwischenverbindungen ist, wobei physikalische und elektrische Eigenschaften von Kohlenstoff-Filmen in Abhängigkeit von den bei der Herstellung der Kohlenstoff-Filme verwendeten Prozessierungs-Parametem dargestellt sind.

Der Erfindung liegt das Problem zugrunde, einen elektrischen Schaltkreis mit einer Nanostruktur und ein Verfahren zum Herstellen einer Kontaktierung einer Nanostruktur zu schaffen, wobei ein Kontaktwiderstand zwischen der Nanostruktur und einer Leiterbahn reduziert ist.

Das Problem wird durch den elektrischen Schaltkreis mit einer Nanostruktur und das Verfahren zum Herstellen einer Kontaktierung einer Nanostruktur mit den Merkmalen gemäß den unabhängigen Patentansprüchen gelöst.

Ein elektrischer Schaltkreis weist zumindest eine Kohlenstoff-Nanostruktur und eine Kohlenstoff-Leiterbahn auf, welche Kohlenstoff-Leiterbahn mittels einer im wesentlichen aus Kohlenstoff bestehenden Schicht ausgebildet ist, wobei die Kohlenstoff-Nanostruktur und die Kohlenstoff-Leiterbahn direkt miteinander gekoppelt sind. Die Kohlenstoff-Leiterbahn weist einen spezifischen Widerstand zwischen 1 µΩcm und 50 µΩcm auf.

Bei einem Verfahren zum Herstellen einer Kontaktierung einer Nanostruktur auf einem Substrat, wird eine Kohlenstoff-Nanostruktur und eine Kohlenstoff-Leiterbahn ausgebildet, wobei die Kohlenstoff-Nanostruktur und die Kohlenstoff-Leiterbahn derart ausgebildet werden, dass sie direkt miteinander gekoppelt sind.

Anschaulich kann ein Aspekt der Erfindung darin gesehen werden, dass anstelle von metallischen Leiterbahnen zum Kontaktieren von Kohlenstoff-Nanostrukturen Leiterbahnen verwendet werden, welche im Wesentlichen aus Kohlenstoff ausgebildet sind. Die Kohlenstoff-Nanostruktur und die Kohlenstoff-Leiterbahn sind direkt miteinander gekoppelt oder anschaulich ausgedrückt die Nanostruktur und die Kohlenstoff-Leiterbahn können im direkten Kontakt stehen, d.h. die Nanostruktur und die Kohlenstoff-Leiterbahn können im Berührungskontakt miteinander stehen. Durch das Verwenden von Kohlenstoff-Leiterbahnen lässt sich für eine Vielzahl von Materialien der Kontaktwiderstand der Kontaktierungen reduzieren. Vorteilhaft an Kohlenstoff-Leiterbahnen ist ferner die sehr gute Prozessierbarkeit von Kohlenstoff und die Möglichkeit der Ausbildung in einfachen Prozessen. Es können auch ganze Metallisierungssysteme, deren Leiterbahnen im wesentlichen Kohlenstoff aufweisen, ausgebildet werden.

Kohlenstoff-Leiterbahnen können hierbei so ausgebildet sein, dass sie einen spezifischen Widerstand aufweisen, welcher vergleichbar mit den von Metallen ist. Insbesondere kann durch Verwendung von Kohlenstoff als Material der Leiterbahnen erreicht werden, dass es bei kleinen Strukturbreiten, d.h. Strukturbreiten von weniger als 100 nm, die Elektronenstreuprozessen in der Leiterbahn reduziert werden, wodurch es nicht zu dem Anstieg des spezifischen Widerstandes kommt, wie er bei Metallen zu beobachten ist, für welche bei Strukturbreiten von weniger als 100 nm der spezifische Widerstand, welcher für makroskopische Systemen gegeben ist, nicht erreichbar ist. Insbesondere der Kontaktwiderstand der Kohlenstoff-Leiterbahnen zu Nanostrukturen, welche Kohlenstoff aufweisen, ist reduziert, da die Stärke der Schottky-Barriere verringert werden kann.

Ein weiterer Vorteil der Verwendung von Kohlenstoff-Leiterbahnen ist, dass der Kohlenstoff gleichzeitig als Diffusionsbarriere wirkt. Somit sind spezielle Diffusionsbarrieren, wie sie beispielsweise bei der Verwendung von Kupfer als Leiterbahn und Siliziumoxid als Dielektrikum verwendet werden, und welche den Herstellungsprozess von elektrischen Schaltkreisen erschweren und verlangsamen, nicht nötig. Auch so genannte Haftvermittlungsschichten sind bei Kohlenstoff-Leiterbahnen nicht nötig, da Kohlenstoff in Gegensatz zu beispielsweise Kuprer auf Siliziumoxid haftet. Solche Diffusionsbarrieren und Haftvermittlungsschichten werden bei der Verwendung von Kupfer als Material der Leiterbahnen üblicherweise aus Tantal-basierten Materialien hergestellt, welche teuer sind. Der gesamte Herstellungsprozess kann somit durch Einsparung von Prozess-Schritten zeitlich verkürzt und kostengünstiger gestaltet werden. Die Zeitdauer für die Abscheidung einer Schicht aus Kohlenstoff, welche als Kohlenstoff-Leiterbahn verwendet wird, ist relativ kurz. Ferner ist auch ein paralleler so genannter Batch-Prozess mit guter Reproduzierbarkeit möglich. Die Kohlenstoffschicht weist hierbei eine Rauhigkeit von 2 nm ± 0,3 nm mit einer durchschnittlichen Korngröße 1 nm bis 2 nm auf.

Eine abgeschiedene Kohlenstoffschicht lässt sich auch auf einfache Weise strukturieren, um eine Kohlenstoff-Leiterbahn auszubilden. Dies ist beispielsweise mittels eines Wasserstoff- und/oder Sauerstoffplasmas und/oder Luftplasmas möglich.

Bevorzugte Weiterbildungen der Erfindung ergeben sich aus den abhängigen Ansprüchen. Die weiteren Ausgestaltungen der Erfindung, die im Zusammenhang mit einem der unabhängigen Ansprüche beschrieben sind, sind sinngemäß in wechselseitiger Weise auch als Ausgestaltungen des jeweils anderen unabhängigen Anspruchs zu verstehen.

Insbesondere das Ausbilden einer Kontaktierung zwischen einer Kohlenstoff-Leiterbahn und einer Kohlenstoff-Nanostruktur ist besonders vorteilhaft, da durch das Verwenden von Kohlenstoff für beide Strukturen der Kontaktwiderstand durch das Verringern der Schottky-Barriere reduziert werden kann. Anschaulich kann beim Ausbilden der Kontaktierung zwischen der Nanostruktur und der Kohlenstoff-Leiterbahn ein Netzwerk ausgebildet werden, bei welchem die Kohlenstoff-Leiterbahn die Nanostruktur zumindest in Teilbereichen umschließt, wodurch ein besonders stabiler und niederohmiger Kontakt ausgebildet werden kann.

Der elektrische Schaltkreis kann einen Transistor aufweisen, bei welchem der Kanalbereich des Transistors die Nanostruktur, insbesondere eine Kohlenstoff-Nanostruktur, aufweist und zumindest einer der Source/Drainbereiche des Transistors die Kohlenstoff-Leiterbahn aufweist. Vorzugsweise weisen beide Source/Drainbereiche des Transistors eine Kohlenstoff-Leiterbahn auf.

Vorzugsweise weist der elektrische Schaltkreis zumindest ein Via auf, welches zwei Ebenen des elektrischen Schaltkreises miteinander verbindet, wobei die Nanostruktur in dem zumindest einem Via angeordnet ist und wobei die Kohlenstoff-Leiterbahn in einer der beiden Ebenen angeordnet ist. Besonders bevorzugt weist der elektrische Schaltkreis eine zusätzliche Kohlenstoff-Leiterbahn auf, welche in der anderen der beiden Ebenen angeordnet ist, welche zusätzliche Kohlenstoff-Leiterbahn ebenfalls die Nanostruktur direkt kontaktiert.

Durch das Vorsehen von zwei Kohlenstoff-Leiterbahnen, welche auf verschiedenen Ebenen eines elektrischen Schaltkreises ausgebildet sind und welche mittels eines Via aus einer Nanostruktur miteinander verbunden werden ist es möglich eine besonders effiziente, d.h. insbesondere niederohmige Verbindung, der beiden Ebenen eines elektrischen Schaltkreises zu schaffen. Das Verwenden der Nanostrukturen zum Ausbilden einer Vertikal-Verbindung oder eines so genannten Via ist eine einfache Art und Weise solche Vias auszubilden. Auch ist es möglich die Nanostrukturen mit einer weiteren Kohlenstoff-Leiterbahn zu umgeben, d.h. anschaulich mittels einer Kohlenstoff-Leiterbahn zu ummanteln, da diese weitere Kohlenstoff-Leiterbahn mittels eines einfachen Abscheideprozesses mit optimaler Kantenbedeckung und sehr guten Fülleigenschaften ausgebildet werden kann. Sowohl mittels Nanostrukturen als auch mittels einer ummantelten Nanostruktur sind Vertikal-Verbindung mit sehr hohen Aspektverhältnissen, d.h. Höhe zu Breite des Via, möglich. Erfindungsgemäß lassen sich Vias mit Aspektverhältnisse von 100 bis 200 realisieren. Ferner ist die elektrische Leitfähigkeit eines solchen Via auch zumindest vergleichbar mit dem von hoch dotierten Polysilizium, welches herkömmlich für Vias verwendet wird, so dass eine ausreichende Leitfähigkeit der Vertikal-Verbindung sichergestellt werden kann. Erfindungsgemäß können auch mehrere Vias ausgebildet sein, in welchem Nanostrukturen angeordnet sind. Auch ist es möglich das mehrere Vias ausgebildet sind, von denen in nur einigen, d.h. nicht in allen, Nanostrukturen angeordnet sind.

Werden innerhalb der einzelnen Ebenen ganze elektronische Komponenten, beispielsweise einzelne Chips, ausgebildet, welche mittels des Via miteinander elektrisch leitend verbunden werden, ist es möglich eine hochintegrierte 3D-Integration von Chips zu erzielen. Insbesondere ist es möglich unterschiedliche Systeme, d.h. Komponenten oder Chips unterschiedlicher Funktion, übereinander zu stapeln und so genannte System-on-Chips (SoC) herzustellen.

In einem Ausführungsbeispiel ist die im Wesentlichen aus Kohlenstoff bestehenden Schicht eine polykristalline Kohlenstoffschicht.

Unter polykristalliner Kohlenstoffschicht wird in der Anmeldung eine Schicht verstanden, welche in Teilbereichen jeweils eine graphitähnliche Struktur, d.h. eine überwiegende sp2 Modifikation, aufweist. Es ist jedoch keine großflächige hexagonale Struktur ausgebildet. Die einzelnen Teilbereiche mit graphitähnlicher Struktur haben eine Größe, welche zu der Korngröße der polykristallinen Kohlenstoffschicht korrespondiert und etwa 1 nm bis 2 nm beträgt. Anschaulich sind die einzelnen Teilbereiche mit hexagonale Graphitstruktur immer wieder durch Bereiche unterbrochen, in denen keine regelmäßige Graphitstruktur vorhanden ist oder in denen die hexagonalen Graphitstrukturen zumindest eine andere Ausrichtung aufweisen.

Anschaulich kann man die einzelnen Teilbereiche mit einer regelmäßigen Graphitstruktur als "kristalline" Bereiche auffassen. Somit weist der polykristalline Kohlenstoff eine Vielzahl von "kristallinen" Bereichen auf. Aus diesem Grunde wurde im Rahmen dieser Anmeldung der Begriff "polykristalliner Kohlenstoff" für das Material gewählt. Die einzelnen kristallinen Bereiche, d.h. die Graphitstrukturen, weisen im Allgemeinen eine Vorzugsrichtung auf, d.h. es bilden sich schichtähnliche Strukturen aus dem polykristallinen Kohlenstoff.

Kohlenstoff-Leiterbahnen mit solchen spezifischen Widerständen, welche vergleichbar mit spezifischen Widerständen von Metallen sind, sind besonders geeignet, um in elektrischen integrierten Schaltkreisen verwendet zu werden. Insbesondere bei der Verwendung der Kohlenstoff-Leiterbahn bei kleinen Strukturgrößen ist der Widerstand der Kohlenstoff-Leiterbahn sogar geringer als der einer metallischen Leiterbahn, weil es bei dieser, wie bereits erwähnt, bei Strukturengrößen von weniger als 100 nm zu Elektronenstreuprozessen kommt. Insbesondere ist der Kontaktwiderstand zu Nanostrukturen verringert. Durch den geringen Widerstand können die RC-Schaltzeiten der elektrischen Schaltkreise verringert werden. Die geringen spezifischen Widerstände lassen sich mit Kohlenstoff-Leiterbahnen erzielen, welche mittels üblicher Dotierstoffe, wie Bor, Phosphor oder Arsen, dotiert sind. Auch eine Interkalation mittels Metallhalogenide, wie beispielsweise Arsenfluorid (AsF₅) oder Antimonfluorid (SbF₅), ist möglich. Bei der Interkalierung mit AsF₅ ist beispielsweise ein spezifischer elektrischer Widerstand von bis zu 1,1 µΩcm erzielbar.

Die spezifischen Widerstände von dotierten Kohlenstoff-Leiterbahnen sind beispielsweise wesentlich geringer als die von hoch dotierten Polysilizium, welches üblicherweise im Stand der Technik für die Ausbildung von Vertikal-Verbindungen verwendet wird. Insbesondere im Vergleich zu hoch dotierten Polysilizium weist die Kohlenstoff-Leiterbahn auch eine bessere thermische Leitfähigkeit auf, wodurch bei der 3D-Integration entstehende Wärme besser abgeleitet werden kann, wodurch einer Chiperwärmung entgegengewirkt werden kann.

In einer Weiterbildung wird zuerst die Nanostruktur auf dem Substrat ausgebildet und anschließend die Kohlenstoff-Leiterbahn an der Nanostruktur ausgebildet.

In einer anderen Weiterbildung wird zuerst die Kohlenstoff-Leiterbahn auf dem Substrat ausgebildet und anschließend die Nanostruktur an der Kohlenstoff-Leiterbahn ausgebildet.

Vorzugsweise wird mittels der Nanostruktur ein Via ausgebildet, welches die Kohlenstoff-Leiterbahn mit einer zweiten Leiterbahn verbindet, wobei die Kohlenstoff-Leiterbahn und die zweite Leiterbahn in unterschiedlichen Ebenen angeordnet sind. Besonders bevorzugt wird die zweite Leiterbahn ebenfalls als eine Kohlenstoff-Leiterbahn ausgebildet, welche vorzugsweise mittels des gleichen Prozesses wie die Kohlenstoff-Leiterbahn ausgebildet wird.

Anschaulich werden beide Leiterbahnen, welche das Via Kontaktieren als Kohlenstoff-Leiterbahnen ausgebildet, wodurch der Kontaktwiderstand auf besonders effiziente Weise gesenkt werden kann, da so die Schottky-Barriere an beiden Kontaktierungen reduziert werden kann.

Die Kohlenstoff-Leiterbahn wird dotiert und/oder interkaliert.

Durch das Dotieren oder Interkalieren ist es möglich auf einfache Weise einen spezifischen Widerstand der Kohlenstoff-Leiterbahn zu erzielen, welche zumindest gleich gut oder besser als die von metallischen Leiterbahnen ist.

Besonders bevorzugt wird die dotierte und/oder interkalierte Kohlenstoff-Leiterbahn thermisch aktiviert.

Insbesondere beim Verwenden von Fluor als Dotierstoff, d.h. wenn Fluor in die Kohlenstoff-Leiterbahn eingebracht wird, ist das thermische Aktivieren ein geeigneter Verfahrensschritt, um die Eigenschaften, beispielsweise den spezifischen Widerstand, der Kohlenstoff-Leiterbahn günstig zu beeinflussen. Die thermische Aktivierung kann durchgeführt werden, indem ein Gas erhitzt wird, welches sich in einer Kammer befindet, in welcher der elektrische Schaltkreis prozessiert wird. Eine alternative Möglichkeit ist es den Wafer selber, auf welchen der elektrische Schaltkreis prozessiert wird, zu erhitzen, beispielsweise über eine elektrische Heizung des so genannten Chucks.

Gemäß der Erfindung wird eine selektive Aktivierung der dotierten und/oder interkalierten Kohlenstoff-Leiterbahn mittels Lasers durchgeführt.

Die Verwendung eines Lasers ist ein besonders geeignetes Mittel um eine selektive Aktivierung der dotierten und/oder interkalierten Kohlenstoff-Leiterbahn durchzuführen, da mittels eines Lasers gezielt Bereiche selektiv thermisch behandelt, d.h. erwärmt, werden können.

Das kohlenstoffhaltige Gas kann Methan, Äthan, Alkoholdampf und/oder Azetylen sein.

Diese kohlenstoffhaltigen Gase sind besonders geeignet, um in dem Verfahren zum Herstellen einer polykristallinen Kohlenstoffschicht verwendet zu werden.

In einer Weiterbildung wird die Kohlenstoff-Leiterbahn in einer Atmosphäre mit einem Wasserstoffpartialdruck zwischen 1 Hektopascal und 5 Hektopascal und bei einer Temperatur zwischen 600°Celsius und 1000°Celsius die Kohlenstoff-Leiterbahn als im wesentlichen aus Kohlenstoff bestehende Schicht mittels Zuführens eines kohlenstoffhaltigen Gases ausgebildet.

Mittels des beschriebenen Prozesses der Abscheidung der Kohlenstoff-Leiterbahn ist es auf einfache Weise möglich eine Im wesentlichen aus Kohlenstoff bestehende Schicht auszubilden, welche einen niedrigen Widerstand und insbesondere einen niedrigen Kontaktwiderstand zu einer Nanostruktur aufweist.

In einem Ausführungsbeispiel beträgt die Temperatur zwischen 900°Celsius und 970°Celsius und der Wasserstoffpartialdruck im wesentlichen 1 Hektopascal und wird beim Ausbilden der Kohlenstoff-Leiterbahn so viel kohlenstoffhaltiges Gas zugeführt, dass sich ein Gesamtdruck zwischen 500 Hektopascal und 700 Hektopascal einstellt.

Alternativ beträgt die Temperatur zwischen 750°Celsius und 850°Celsius, der Wasserstoffpartialdruck im wesentlichen 1,5 Hektopascal und wird beim Ausbilden der Kohlenstoff-Leiterbahn so viel kohlenstoffhaltiges Gas zugeführt, dass sich ein Partialdruck des kohlenstoffhaltigen Gases zwischen 9 Hektopascal und 11 Hektopascal einstellt.

Unter diesen vorgegebenen Bedingungen ist eine Ausbildung einer Schicht für eine Kohlenstoff-Leiterbahn und einen spezifischen Widerstand von weniger als 1 mΩcm besonders effektiv und auf einfache Weise durchführbar.

Bevorzugt wird die Temperatur zumindest teilweise mittels einer Photonen-Heizung und/oder mittels Heizens des Substrates auf einer Hot-Plate aufrecherhalten wird.

Das Verwenden einer Photonen-Heizung, oder einer Hot-Plate oder anders ausgedrückt über eine so genannte Chuck-Heizung, also einer Heizung, welche den Chuck heizt, auf welchem das Substrat angeordnet ist, um zumindest einen Teil der Energie des Heizens auf die benötigte Temperatur bereitzustellen, ist vorteilhaft, da sich gezeigt hat, dass in diesem Fall die Temperatur im Verfahren gesenkt werden kann. Hierdurch wird beim Durchführen des Verfahrens eine geringere Energiezufuhr benötigt und die Gefahr einer Zerstörung oder Schädigung von Schichten, welche bereits auf oder in dem Substrat ausgebildet sind, wird reduziert.

Bevorzugt wird das Ausbilden der Kohlenstoff-Leiterbahn mittels eines Hochfrequenzplasmas und/oder eines Mikrowellenplasmas unterstützt.

Das Verwenden eines Hochfrequenzplasmas und/oder eines Mikrowellenplasmas ermöglicht es die Abscheidetemperatur der Kohlenstoffschicht zu senken.

Zusammenfassend kann ein Aspekt der Erfindung darin gesehen werden, dass mittels der Erfindung eine Alternative für bisher verwendete Materialien für Leiterbahnen zum Kontaktieren von Nanostrukturen geschaffen wird. Anstelle der bisherigen Verwendung von Metallen wird ein kohlenstoffbasiertes Material verwendet, mittels welchem Material Kohlenstoff-Leiterbahnen ausgebildet werden. Die Kohlenstoff-Leiterbahnen zeichnen sich durch sehr einfache und kostengünstige Herstellung und einfache Prozessierbarkeit aus. Ferner ist der Kontaktwiderstand zwischen der Nanostruktur und der Kohlenstoff-Leiterbahn geringer, insbesondere wenn die Nanostruktur als eine Kohlenstoff-Nanostruktur ausgebildet ist, da hierbei die Schottky-Barriere reduziert wird. Die Kohlenstoff-Nanostruktur kann hierbei als so genannte Single-Wall Kohlenstoff-Nanoröhre (SWCNT) oder als so genannte Multi-Wall Kohlenstoff-Nanoröhre ausgebildet sein.

Ferner weist die Kohlenstoff-Leiterbahn, insbesondere bei kleinen Strukturen oder gegenüber dotierten Polysilizium, einen geringeren spezifischen Widerstand als bisher übliches Material für Leiterbahnen in Metallisierungssystemen auf. Hierdurch ist es möglich die Schaltzeiten der integrierten Schaltkreise zu verkleinern, d.h. die integrierten Schaltkreise mit einem schnelleren Takt zu betreiben. Ein weiterer Vorteil von dotierten Kohlenstoff ist, dass auch die thermische Leitfähigkeit des dotierten Kohlenstoffes besser ist, wodurch eine bessere thermische Kopplung zwischen verschiedenen Komponenten bei der 3D-Integration von integrierten Schaltkreisen erreicht werden kann, was zu einer verbesserten Wärmeabfuhr nach außen führt.

In einer anderen Ausgestaltung der Erfindung ist es vorgesehen, eine oder mehrere Kohlenstoff-Nanoröhren mit einer wie oben beschriebenen Kohlenstoffschicht zu kontaktieren. Gemäß dieser Ausgestaltung ist/sind die Kohlenstoff-Nanoröhre(n) als lichtemittierende Elemente eingerichtet und dienen somit anschaulich als Leuchtdioden.

Ausführungsbeispiele der Erfindung werden in den Figuren dargestellt und werden im Weiteren näher erläutert.

Es zeigen:
- Figur 1a: eine schematische Schnittansicht einer Schichtanordnung nach ersten Teilschritten eines Verfahrens gemäß einem Ausführungsbeispiel zum Herstellen eines Transistors;
- Figur 1b: eine schematische Schnittansicht der Schichtanordnung aus Figur 1a nach zusätzlichen Teilschritten des Verfahrens, welche hauptsächlich dem Ausbilden eines dünnen Kohlenstoff-Film dienen;
- Figur 1c: eine schematische Schnittansicht der Schichtanordnung aus Figur 1b nach zusätzlichen Teilschritten des Verfahrens, welche hauptsächlich dem Ausbilden einer Ätzmaske dienen;
- Figur 1d: eine schematische Schnittansicht der Schichtanordnung aus Figur 1c nach zusätzlichen Teilschritten des Verfahrens, welche hauptsächlich dem Strukturieren der Ätzmaske dienen;
- Figur 1e: eine schematische Schnittansicht der Schichtanordnung aus Figur 1d nach zusätzlichen Teilschritten des Verfahrens, welche hauptsächlich dem Strukturieren des dünnen Kohlenstoff-Films dienen;
- Figur 2: eine Raster-Elektonenmikroskop-Aufnahme eines Substrats, welches ein Netzwerk aus Kohlenstoff-Nanoröhren und einer Kohlenstoff-Leiterbahn aufweist;
- Figur 3a: Diagramme gemessener so genannter Abbrennkurven von Kohlenstoff-Nanoröhren;
- Figur 3b: Transistorkennlinien von Kohlenstoff-Nanoröhren vor und nach dem Ausbilden einer Kohlenstoff-Leiterbahn; und
- Figur 4: eine schematische Darstellung eines Kohlenstoff-Nanoröhren Via, welches mittels zweier Kohlenstoff-Leiterbahnen kontaktiert ist.

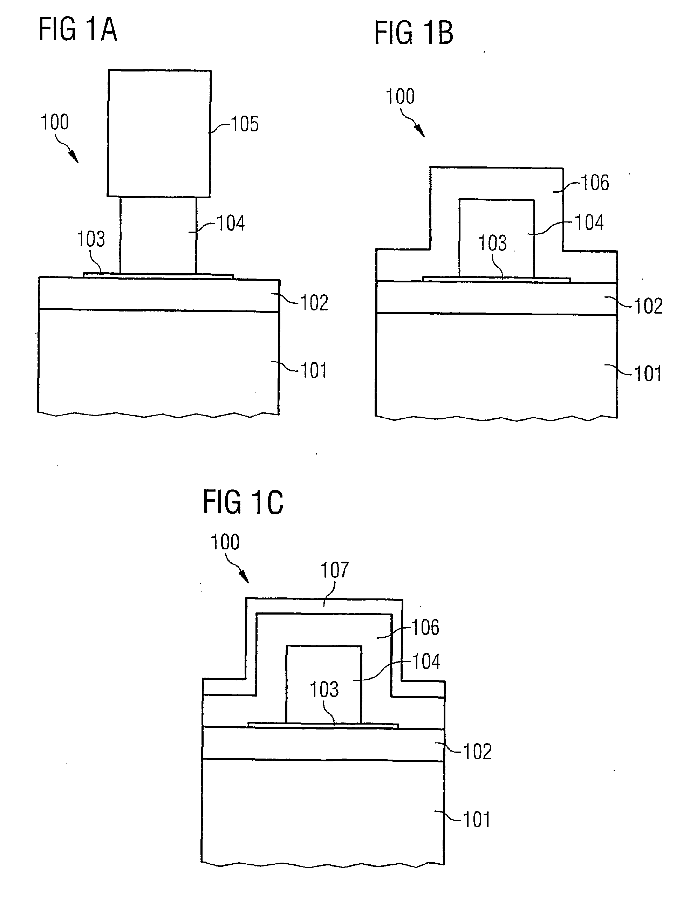

**Fig.1a** zeigt eine schematische Darstellung einer Schichtanordnung 100 nach ersten Teilschritten eines Verfahrens gemäß einem ersten Ausführungsbeispiel zum Herstellen eines elektrischen Schaltkreises mit Kohlenstoff-Leiterbahnen, welche zum Kontaktieren von Kohlenstoff-Nanoröhren verwendet werden, wobei der elektrische Schaltkreis ein Kohlenstoff-Nanoröhren Felddeffekt-Transistor (CNT-FET) ist.

Auf einem Substrat 101, welches zusätzlich gemäß diesem Ausführungsbeispiel der Erfindung als Gateelektrode dient und aus Silizium gebildet ist, wird eine Siliziumoxidschicht 102 ausgebildet. Auf der Siliziumoxidschicht 102 wird nachfolgend mittels an sich bekannter Verfahren eine Lage von Kohlenstoff-Nanoröhren 103 ausgebildet, aus welchen im Verlauf des Verfahrens der Kanalbereich des CNT-FET ausgebildet wird.

Beispielsweise können Kohlenstoff-Nanoröhren hergestellt werden, indem auf einem Substrat, in diesem Fall die Siliziumoxidschicht 102 eine Katalysatormaterial-Schicht, beispielsweise aus Eisen, Kobalt oder Nickel, abgeschieden wird und auf dieser Katalysatormaterial-Schicht unter Verwendung eines CVD-Verfahrens ("chemical vapour deposition") mittels Einleitens eines kohlenstoffhaltigen Materials (beispielsweise Azetylen) in die Verfahrenskammer Kohlenstoff-Nanoröhren auf der Katalysatormaterial-Schicht aufgewachsen werden.

Zumindest auf einem Teil der Lage von Kohlenstoff-Nanoröhren 103 wird eine Schicht 104 aus TEOS (Tetraethylorthosilikat), alternativ aus SOG (Spin-on-Glass), ausgebildet.

Unter Bezugnahme auf die **Fig.1b** werden Teilschritte des Verfahrens gemäß dem Ausführungsbeispiel der Erfindung erläutert, welche hauptsächlich dem Ausbilden einer dünnen Kohlenstoffschicht oder Kohlenstofffilms dienen.

Von der Schichtenfolge 100 der Fig.1a wird zur Strukturierung der Schicht 104 verwendeter, aufgebrachter Fotolack 105 entfernt und nachfolgend wird eine dünne Kohlenstoffschicht 106 ausgebildet, welche polykristalline Eigenschaften hat. Zum Ausbilden der polykristallinen Kohlenstoffschicht 106 können verschiedene Prozesse verwendet werden. Unter einer polykristallinen Kohlenstoffschicht wird eine Schicht verstanden, welche im wesentlichen aus Kohlenstoff besteht und welche in Teilbereichen eine Graphitstruktur, d.h. eine hexagonale Gitterstruktur, welche als kristallin aufgefasst werden kann, aufweist. Die einzelnen "kristallinen" Teilbereiche mit hexagonalen Strukturen sind jedoch durch Bereiche getrennt, welche keine hexagonalen Gitterstrukturen aufweisen, oder zumindest durch hexagonale Gitterstrukturen getrennt, welche eine zu den benachbarten "kristallinen" Teilbereichen verschieden angeordnete Ausrichtung aufweisen.

Die Schicht 104 dient somit anschaulich dazu, dass die Kohlenstoffschicht 106 unterbrochen ist und der gebildete Kohlenstoff-Nanoröhren-Transistor nicht kurzgeschlossen ist. Es ist in diesem Zusammenhang darauf hinzuweisen, dass die beschriebene Prozessfolge nicht einschränkend und lediglich als ein Beispiel vieler möglicher Prozessvarianten zu verstehen ist.

Allgemein ist aus obigem Beispiel die besondere Eignung der Kohlenstoffschicht als Elektrode eines elektronischen Bauelements ersichtlich.

Bei einem ersten Prozess wird bei einer Temperatur zwischen 900°Celsius und 970°Celsius, vorzugsweise 950°Celsius, eine Wasserstoffatmosphäre mit einem Druck von etwa 0,001 bar, oder 1 Hektopascal, erzeugt. Anschließend wird ein kohlenstoffhaltiges Gas beispielsweise Methan (CH₄) oder Azetylen (C₂H₄) eingeleitet, bis sich ein Gesamtdruck von etwa 0,6 bar, oder 600 Hektopascal, einstellt. Bei diesen Bedingungen scheidet sich eine polykristalline Kohlenstoffschicht auf der Oberfläche der Schichtanordnung 100 ab. Vorzugsweise wird das kohlenstoffhaltige Gas während des Abscheideprozesses ständig eingeleitet, so dass der Gesamtdruck im wesentlichen konstant bleibt.

Bei einem zweiten Prozess zum Erzeugen einer polykristallinen Kohlenstoffschicht wird bei einer Temperatur von etwa 800°Celsius eine Wasserstoffatmosphäre von etwa 2 Torr bis 3 Torr, vorzugsweise 2,5 Torr, was etwa 3,33 Hektopascal entspricht, erzeugt. Gleichzeitig zum Heizen mittels eines normalen Ofens wird ein so genannter Photonen-Ofen verwendet, d.h. eine Lichtquelle, welche zusätzlich Energie zur Verfügung stellt. Hierdurch lässt sich die Temperatur gegenüber dem oben beschriebenen Verfahren senken, was je nach Anwendungsgebiet vorteilhaft sein kann. In die Wasserstoffatmosphäre wird anschließend wiederum ein kohlenstoffhaltiges Gas beispielsweise Methan (CH₄), Azetylen (C₂H₄) oder Alkoholdampf, vorzugsweise Äthanoldampf (C₂H₅OH), eingeleitet, bis ein Gesamtdruck zwischen 6,5 Torr und 8,5 Torr, vorzugsweise 7,5 Torr, was etwa 10 Hektopascal entspricht, erreicht ist.

Auch bei diesen Bedingungen scheidet sich eine polykristalline Kohlenstoffschicht ab. Auch in diesem Prozess wird das kohlenstoffhaltige Gas vorzugsweise ständig eingeleitet, solange die konforme Abscheidung durchgeführt wird.

In allen beschriebenen Prozessen kann die Dicke der Kohlenstoffschicht über die Dauer des Abscheideprozesses gesteuert werden.

Unter Bezugnahme auf die **Fig.1c** werden Teilschritte des Verfahrens gemäß dem Ausführungsbeispiel der Erfindung erläutert, welche hauptsächlich dem Ausbilden einer Ätzmaske dienen.

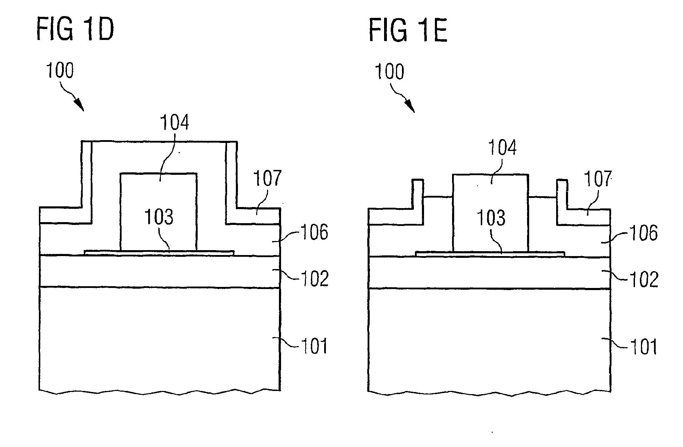

Zum Ausbilden der Ätzmaske wird eine Metallschicht 107 geeigneter Dicke aus Titan oder Gold auf der dünnen Kohlenstoffschicht 106 ausgebildet. Eine geeignete Dicke kann je nach Anwendung etwa 20 nm sein. Nachfolgend wird die dünne Schicht 107 aus Gold oder Titan mechanisch derart poliert, dass Teilbereiche der dünnen Kohlenstoffschicht 106 im Bereich der Gateeinkapselung 105 freigelegt werden, was in **Fig.1d** schematisch dargestellt ist.

Nachfolgend wird die dünne Kohlenstoffschicht 106 unter Verwendung der verbliebenen Ätzmaskenschicht 107 so strukturiert, dass mittels ihr ein erster Source/Drainbereich 108 und ein zweiter Source/Drainbereich 109 ausgebildet wird, was schematisch in **Fig.1e** gezeigt ist. Die beiden Source/Drainbereiche 108 und 109 kontaktieren hierbei die Kohlenstoff-Nanoröhren 103, welche den Kanalbereich des Transistors bilden. Das Strukturieren der dünnen Kohlenstoffschicht 106 kann beispielsweise mittels H₂-Plasmaätzens durchgeführt werden.

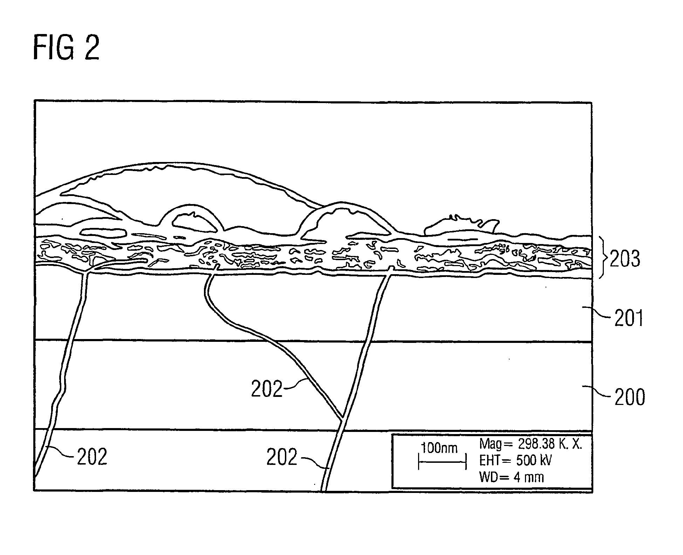

In **Fig.2** ist eine Raster-Elektonenmikroskop-Aufnahme eines Substrats, welches ein Netzwerk aus Kohlenstoff-Nanoröhren und Kohlenstoff-Leiterbahn aufweist, gezeigt, und welches im wesentlichen der in Fig.1a gezeigten Schichtenfolge entspricht, bevor der Gatebereich ausgebildet wurde. Man erkennt ein Siliziumsubstrat 200, auf welchem eine Siliziumoxidschicht 201 ausgebildet ist. Auf der Siliziumoxidschicht 201 wurde eine Lage von Kohlenstoff-Nanoröhren 202 ausgebildet, auf welcher nachfolgend eine dünne Schicht aus Kohlenstoff 203 ausgebildet wurde. Zum Überprüfen, ob die Kohlenstoff-Nanoröhren den nachfolgenden Prozess des Ausbildens der Kohlenstoffschicht 203 unbeschadet überstehen, wurde das Substrat 200 gebrochen und eine Raster-Elektonenmikroskop-Aufnahme der entstehenden Bruchkante aufgenommen, welche in Fig.2 dargestellt ist. Man erkennt Kohlenstoff-Nanoröhren, welche als helle Fäden in der Fig.2 zu sehen sind und welche aus der Kohlenstoffschicht 203 und aus der Bruchkante hinausragen. Somit zeigt Fig.2, dass die Kohlenstoff-Nanoröhren eine nachfolgende Ausbildung einer polykristallinen Kohlenstoffschicht mittels eines oben beschriebenen Prozesses unbeschadet überstehen.

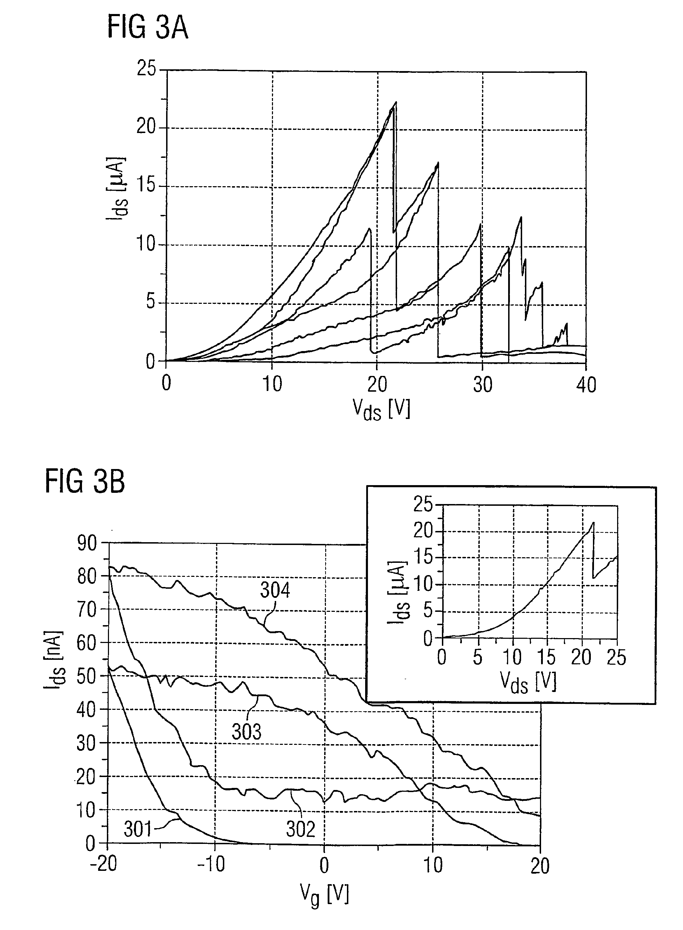

In **Fig.3a** sind Diagramme gemessener so genannter Abbrennkurven von Kohlenstoff-Nanoröhren, welche in einem CNT-FET verwendet werden, welche CNT-FET mittels eines in den Fig.1a bis 1e beschriebene Prozesses hergestellt wurden, gezeigt. Aufgetragen ist die Stromstärke I_{ds} in µA zwischen Drain- und Sourceanschluss gegen die Potentialdifferenz V_{ds} in Volt zwischen Drain- und Sourceanschluss. Erkennbar sind so genannten Abbrennkurven, d.h. die Kurven zeigen ein Anwachsen des Drain-Source-Stromes mit steigender Potentialdifferenz bis zu einen Punkt an dem die Kohlenstoff-Nanoröhren abbrennen und der Drain-Source-Strome schlagartig zurückgeht. Fig.3a zeigt, dass die Kohlenstoff-Nanoröhren sowohl die Ausbildung der polykristallinen Kohlenstoffschicht, als auch einen bei der Herstellung des CNT-FET durchgeführten Spin-On-Glass Prozess bei hohen Temperaturen von 950°Celsius unbeschadet überstehen, d.h. die intrinsischen Eigenschaften der Kohlenstoff-Nanoröhren bleiben auch nach einer Kontaktierung mittels Kohlenstoff erhalten. Es wurden Maximalströme zwischen 10 µA und 25 µA erzielt, was Stromdichten im Bereich von etwa 10⁸ A/cm² entspricht.

**Fig.3b** zeigt Kennlinien eines CNT-Feldeffekttransisitors, bei dem die Kontaktierung des Kanalbereichs mittels Kohlenstoff-Leiterbahnen, d.h. mittels Source/Drainbereichen aus polykristallinem Kohlenstoff, ausgebildet ist. Bei den Kennlinien in Fig.3b ist der Strom (in Nanoampere) zwischen Sourcebereich und Drainbereich über der Spannung (in Volt) am Gate des CNT-Feldeffekttransisitors aufgetragen. CNT-Feldeffekttransistoren haben typischerweise eine Hysterese in ihrer Kennlinie, wie in Fig. 3b gezeigt. Die Kennlinie mit Hysterese vor dem Abbrennen des CNT-Feldeffekttransisitors ist in Fig.3b mit den Bezugszeichen 302 und 304 bezeichnet. Die Kennlinie mit Hysterese nach dem Abbrennen der metallischen Kohlenstoff-Nanoröhren (CNTs) des CNT-Feldeffekttransisitors ist in Fig.3b mit den Bezugszeichen 301 und 303 bezeichnet. In der Kennlinie 302, 304 ist insbesondere ein großer Offsetstrom I_{offset} gezeigt. In der Kennlinie 301, 303 ist demgegenüber insbesondere ein sich ergebender geringer Offsetstrom I_{offset} gezeigt.

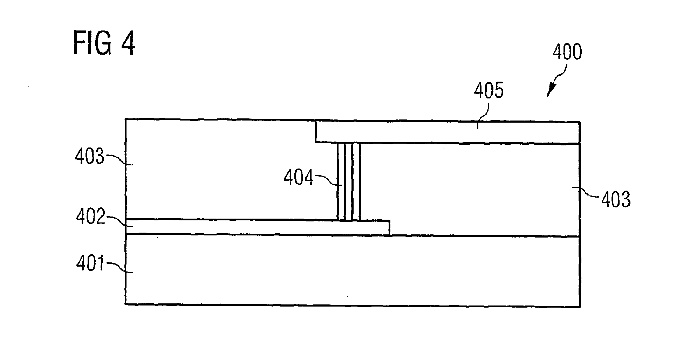

In **Fig.4** ist eine schematische Darstellung einer Schichtenfolge 400 mit Kohlenstoff-Nanoröhren, welche als Via mittels zweier Kohlenstoff-Leiterbahnen kontaktiert sind, gezeigt.

Die Schichtenfolge 400, weist ein Substrat 401 auf, auf welchem eine erste Kohlenstoff-Leiterbahn 402 ausgebildet ist. Auf dieser ersten Kohlenstoff-Leiterbahn 401 ist eine Passivierungsschicht 403 ausgebildet. Die Passivierungsschicht 403 wurde strukturiert und ein Durchgangsloch ausgebildet, welches einen Teilbereich der ersten Kohlenstoff-Leiterbahn 402 freilegt. In dem Durchgangsloch wurden dann mittels der bekannten Herstellungsprozesse, d.h. einem Ausbilden einer Katalysatorschicht beispielsweise aus Eisen, Kobalt oder Nickel und einem darauf Aufwachsen der Kohlenstoff-Nanoröhren, auf der ersten Kohlestoff-Leiterbahn 401 Kohlenstoff-Nanoröhren 404 gewachsen, welche in Fig.4 schematisch und nicht maßstäblich gezeigt sind. Ferner weist die Schichtenfolge 400 eine zweite Kohlenstoff-Leiterbahn 405 auf, welche wie die erste Kohlenstoff-Leiterbahn 402 die Kohlenstoff-Nanoröhren 404 kontaktiert und ebenso wie die erste Kohlenstoff-Leiterbahn 402 mittels eines der in Bezug auf Fig.1 erläuterten Prozesse hergestellt wurde.

Zusammenfassend kann ein Aspekt der Erfindung darin gesehen werden, einen elektrischen Schaltkreis mit einer Nanostruktur und ein Verfahren zum Herstellen einer Kontaktierung einer Nanostruktur, insbesondere einer Kohlenstoff-Nanostruktur, zu schaffen, welche Kontaktierung einen geringen Kontaktwiderstand aufweist. Erfindungsgemäß wird zur Kontaktierung eine so genannte polykristallinen Kohlenstoffschicht verwendet, welche den Kontaktwiderstand, insbesondere die Schottky-Barriere, zu einer Nanostruktur senkt, insbesondere wenn diese als Kohlenstoff-Nanostruktur, beispielsweise als Kohlenstoff-Nanoröhre, ausgebildet ist. Das Verfahren zum Herstellen der polykristallinen Kohlenstoffschicht basiert auf einfachen und gebräuchlichen Prozessschritten, welche mit dem Verwenden einer Kohlenstoff-Nanostruktur kompatibel sind, d.h. vorhandene Kohlenstoff-Nanostrukturen werden nicht bei einem nachfolgenden Ausbildungsprozess der polykristallinen Kohlenstoffschicht zerstört. Ferner ist es möglich die spezifische Leitfähigkeit des polykristallinen Kohlenstoff weiter zu erhöhen, indem eine Dotierung oder eine so genannte Interkalierung, des polykristallinen Kohlenstoff durchgeführt wird.

In der Anmeldung sind folgende Dokumente zitiert:
[1] R. Martel et al., "Ambipolar Electrical Transport in Semiconducting Single-Wall Carbon Nanotubes", Physical Review Letters, Vol. 87 Nr. 25 (2001) Art. 265805
[2] S. Heinze et al., "Carbon Nanotubes as Schottky Barrier Transistors", Physical Review Letters, Vol. 89 Nr. 10 (2002) Art. 106801
[3] A. Javey et al., "Ballistic Carbon Nanotube Field-Effect Transistors", Nature, Vol. 424 (August 2003) S. 654-657
[4] Graham et al., "Towards the integration of carbon nanotuves in microelectronics" in Diamond and Related Materials, Vol. 13, April-August 2004, S. 1296-1300
[5] DE 198 56 295 C2
[6] EP 1 496 554 A2
[7] W. Yu, J. Zhang, X. Liu, W. Xi, Diamond Rel. Mater. 12 (2003) 2203-2207
[8] WO 02/11216 A
[9] M. Nihei, M. Horibe, A. Kawabata, Y. Awano, Jap. J. Appl. Phys. 43 (2004) 1856-1859
[10] S. C. H. Hung, J. L. Hoyt, J. F. Gibbons, Mat. Res. Soc. Symp. Proc. 427 (1996) 317-322

### Bezugszeichenliste

- 100: Schichtanordnung
- 101: Substrat
- 102: Siliziumoxidschicht
- 103: Kohlenstoff-Nanoröhren
- 104: Schicht aus nichtleitfähigen Material
- 105: Fotolack
- 106: dünne Kohlenstoffschicht
- 107: Metallschicht
- 108: erster Source/Drainbereich
- 109: zweiter Source/Drainbereich
- 200: Siliziumsubstrat
- 201: Siliziumoxidschicht
- 202: Kohlenstoff-Nanoröhren
- 203: dünne Kohlenstoffschicht
- 301: erste Kennlinie
- 302: zweite Kennlinie
- 303: dritte Kennlinie
- 304: vierte Kennlinie
- 400: Schichtenfolge
- 401: Substrat
- 402: erste Kohlenstoff-Leiterbahn
- 403: Passivierungsschicht
- 404: Kohlenstoff-Nanoröhren
- 405: zweite Kohlenstoff-Leiterbahn

## Patentansprüche

1. Elektrischer Schaltkreis mit zumindest einer Kohlenstoff-Nanostruktur (103, 404) und einer Kohlenstoff-Leiterbahn (402, 405), welche mittels einer im wesentlichen aus Kohlenstoff bestehenden Schicht ausgebildet ist, wobei die Kohlenstoff-Nanostruktur (103, 404) und die Kohlenstoff-Leiterbahn (402, 405) direkt miteinander gekoppelt sind und die Kohlenstoff-Leiterbahn (402, 405) einen spezifischen Widerstand zwischen 1 µΩcm und 50 µΩcm aufweist.

2. Elektrischer Schaltkreis gemäß Anspruch 1, bei dem die Kohlenstoff-Nanostruktur (103, 404) eine Nanoröhre oder ein Nanodraht ist.

3. Elektrischer Schaltkreis gemäß einen der Ansprüche 1 bis 2, bei dem der elektrische Schaltkreis einen Transistor aufweist, bei welchem der Kanalbereich des Transistors die Kohlenstoff-Nanostruktur (103, 404) aufweist und einer der Source/Drainbereiche des Transistors die Kohlenstoff-Leiterbahn (402, 405) aufweist.

4. Elektrischer Schaltkreis gemäß einem der Ansprüche 1 bis 2, welcher zumindest ein Via aufweist, welches zwei Ebenen des elektrischen Schaltkreises miteinander verbindet, bei dem die Kohlenstoff-Nanostruktur (103, 404) in dem zumindest einem Via angeordnet ist und bei dem die Kohlenstoff-Leiterbahn (402, 405) in einer der beiden Ebenen angeordnet ist.

5. Elektrischer Schaltkreis gemäß Anspruch 4, bei dem eine zusätzliche Kohlenstoff-Leiterbahn (402, 405) in der anderen der beiden Ebenen angeordnet ist, welche zusätzliche Kohlenstoff-Leiterbahn (402, 405) ebenfalls direkt mit der Kohlenstoff-Nanostruktur (103, 404) gekoppelt ist.

6. Elektrischer Schaltkreis gemäß einem der Ansprüche 1 bis 5, bei dem die im wesentlichen aus Kohlenstoff bestehenden Schicht eine polykristalline Kohlenstoffschicht ist.

7. Verfahren zum Herstellen einer Kontaktierung einer Nanostruktur auf einem Substrat, bei welchem
- eine Kohlenstoff-Nanostruktur (103, 404) und
- eine Kohlenstoff-Leiterbahn (402, 405) ausgebildet wird, und
- wobei die Kohlenstoff Nanostruktur (103, 404) und die Kohlenstoff-Leiterbahn (402, 405) derart ausgebildet werden, dass sie sich direkt kontaktieren,
- die Kohlenstoff-Leiterbahn (402, 405) dotiert und/oder interkaliert wird, und
- eine selektive Aktivierung der dotierten und/oder interkalierten Kohlenstoff-Leiterbahn (402, 405) mittels eines Lasers durchgeführt wird.

8. Verfahren gemäß Anspruch 7, bei dem die Kohlenstoff-Nanostruktur (103, 404) auf dem Substrat ausgebildet wird und die Kohlenstoff-Leiterbahn (402, 405) an der Kohlenstoff-Nanostruktur (103, 404) ausgebildet wird.

9. Verfahren gemäß Anspruch 7, bei dem die Kohlenstoff-Leiterbahn (402, 405) auf dem Substrat ausgebildet wird und die Kohlenstoff-Nanostruktur (103, 404) an der Kohlenstoff-Leiterbahn (402, 405) ausgebildet wird.

10. Verfahren gemäß Anspruch 7, bei dem eine Aktivierung der dotierten und/oder interkalierten Kohlenstoff-Leiterbahn (402, 405) thermisch aktiviert wird.

11. Verfahren gemäß einem der Ansprüche 8 bis 10, bei dem beim Ausbilden der Kohlenstoff-Leiterbahn (402, 405) in einer Atmosphäre mit einem Wasserstoffpartialdruck zwischen 1 Hektopascal und 5 Hektopascal und bei einer Temperatur zwischen 600° Celsius und 1000° Celsius die Kohlenstoff-Leiterbahn (402, 405) als im wesentlichen aus Kohlenstoff bestehende Schicht mittels Zuführens eines kohlenstoffhaltigen Gases ausgebildet wird.

12. Verfahren gemäß Anspruch 11, bei dem das kohlenstoffhaltige Gas Methan, Äthan, Alkoholdampf und/oder Azetylen ist.

13. Verfahren gemäß einem der Ansprüche 11 oder 12, bei dem die Temperatur zwischen 900° Celsius und 970° Celsius, der Wasserstoffpartialdruck 1 Hektopascal beträgt und beim Ausbilden der Kohlenstoff-Leiterbahn (402, 405) so viel kohlenstoffhaltiges Gas zugeführt wird, dass sich ein Gesamtdruck zwischen 500 Hektopascal und 700 Hektopascal einstellt.

14. Verfahren gemäß einem der Ansprüche 11 oder 12, bei dem die Temperatur zwischen 750° Celsius und 850° Celsius, der Wasserstoffpartialdruck 1,5 Hektopascal beträgt und beim Ausbilden der Kohlenstoff-Leiterbahn (402, 405) so viel kohlenstoffhaltiges Gas zugeführt wird, dass sich ein Partialdruck des kohlenstoffhaltigen Gases zwischen 9 Hektopascal und 11 Hektopascal einstellt.

15. Verfahren gemäß einem der Ansprüche 11 bis 14, bei dem die Temperatur zumindest teilweise mittels einer Photonen-Heizung und/oder mittels Heizens des Substrates auf einer Hot-Plate aufrecht erhalten wird.

16. Verfahren gemäß einem der Ansprüche 11 bis 15, bei dem das Ausbilden der Kohlenstoff-Leiterbahn (402, 405) mittels eines Hochfrequenzplasmas und/oder eines Mikrowellenplasmas unterstützt wird.

## Claims

1. Electric circuit having at least a carbon nanostructure (103, 404) and a carbon conductive path (402, 405) which is formed by a layer substantially consisting of carbon, wherein the carbon nanostructure (103, 104) and the carbon conductive path (402, 405) are directly coupled with each other and the carbon conductive path (402, 405) has a resistivity between 1 µΩcm and 50 µΩcm.

2. Electric circuit according to claim 1, wherein the carbon nanostructure (103, 404) is a nanotube or a nanowire.

3. Electric circuit according to any of claims 1 to 2, wherein the electric circuit comprises a transistor where the channel region of the transistor comprises the carbon nanostructure (103, 404) and one of the source/drain regions of the transistor comprises the carbon conductive path (402, 405).

4. Electric circuit according to any of claims 1 to 2, comprising at least one via connecting two planes of the electric circuit to each other, wherein the carbon nanostructure (103, 104) is arranged in the at least one via, and wherein the carbon conductive path (402, 405) is arranged in one of the two planes.

5. Electric circuit according to claim 4, wherein an additional carbon conductive path (402, 405) is arranged in the other one of the two planes, which additional carbon conductive path (402, 405) is also coupled directly with the carbon nanostructure (103, 104).

6. Electric circuit according to any of claims 1 to 5, wherein the layer substantially consisting of carbon is a polycrystalline carbon layer.

7. Method of establishing a contacting of a nanostructure on a substrate, wherein:
- a carbon nanostructure (103, 404) and
- a carbon conductive path (402, 405) are formed, and
- wherein the carbon nanostructure (103, 404) and the carbon conductive path (402, 405) are formed so as to contact each other directly,
- the carbon conductive path (402, 405) is doped and/or intercalated, and
- a selective activation of the doped and/or intercalated carbon conductive path (402, 405) is carried out by means of a laser.

8. Method according to claim 7, wherein the carbon nanostructure (103, 404) is formed on the substrate and the carbon conductive path (402, 405) is formed on the carbon nanostructure (103, 404).

9. Method according to claim 7, wherein the carbon conductive path (402, 405) is formed on the substrate and the carbon nanostructure (103, 404) is formed on the carbon conductive path (402, 405).

10. Method according to claim 7, wherein an activation of the doped and/or intercalated carbon conductive path (402, 405) is thermally activated.

11. Method according to any of claims 8 to 10, wherein, when the carbon conductive path (402, 405) is formed in an atmosphere with a hydrogen partial pressure between 1 hPa and 5 hPa and a temperature between 600°C and 1000°C, the carbon conductive path (402, 405) is formed as a layer substantially consisting of carbon by means of supplying a gas containing carbon.

12. Method according to claim 11, wherein the gas containing carbon is methane, ethane, alcohol vapor, and/or acetylene.

13. Method according to any of claims 11 or 12, wherein the temperature is between 900°C and 970°C, the hydrogen partial pressure amounts to 1 hPa, and, when forming the carbon conductive path (402, 405), so much gas containing carbon is supplied that a total pressure between 500 hPa and 700 hPa is generated.

14. Method according to any of claims 11 or 12, wherein the temperature is between 750°C and 850°C, the hydrogen partial pressure amounts to 1.5 hPa, and, when forming the carbon conductive path (402, 405), so much gas containing carbon is supplied that a partial pressure between 9 hPa and 11 hPa is generated.

15. Method according to any of claims 11 to 14, wherein the temperature is maintained at least in part by means of a photon heater and/or by means of heating the substrate on a hot plate.

16. Method according to any of claims 11 to 15, wherein the forming of the carbon conductive path (402, 405) is supported by means of a high-frequency plasma and/or a microwave plasma.

## Revendications

1. Circuit électrique comprenant au moins une nanostructure (103, 404) de carbone et une piste conductrice (402, 405) de carbone, qui est formée au moyen d'une couche constituée essentiellement de carbone, la nanostructure (103, 404) de carbone et la piste conductrice (402, 405) de carbone étant couplées directement l'une avec l'autre et la piste conductrice (402, 405) de carbone ayant une résistance spécifique comprise entre 1 µΩcm et 50 µΩcm.

2. Circuit électrique suivant la revendication 1, dans lequel la nanostructure (103, 404) de carbone est un nanotube ou est un nanofil.

3. Circuit électrique suivant l'une des revendications 1 à 2, dans lequel le circuit électrique comporte un transistor, dans lequel la zone de canal du transistor comporte la nanostructure (103, 404) de carbone et l'une des zones de source/drain du transistor comporte la piste conductrice (402, 405) de carbone.

4. Circuit électrique suivant l'une des revendications 1 à 2, qui comporte au moins une traversée, qui relie entre eux au moins deux plans du circuit électrique, dans lequel la nanostructure (103, 404) de carbone est disposée dans au moins une traversée et dans laquelle la piste conductrice (402, 405) de carbone est disposée dans l'un des deux plans.

5. Circuit électrique suivant la revendication 4, dans lequel une piste conductrice (402, 405) de carbone supplémentaire est disposée dans l'autre des deux plans, piste conductrice (402, 405) de carbone supplémentaire qui est couplée également directement à la nanostructure (103, 404) de carbone.

6. Circuit électrique suivant l'une des revendications 1 à 5, dans lequel la couche constituée essentiellement de carbone est une couche de carbone polycristalline.

7. Procédé pour ménager une mise en contact d'une nanostructure sur un substrat, dans lequel
- on forme une nanostructure (103, 404) de carbone et
- une piste conductrice (402, 405) de carbone, et
- dans lequel on forme la nanostructure (103, 404) de carbone et la piste conductrice (402, 405) de carbone, de manière à ce qu'elles soient directement en contact,
- on dope la piste conductrice (402, 405) de carbone et/ou on l'intercale, et
- on effectue une activation sélective de la piste conductrice (402, 405) de carbone dopée et/ou intercalée au moyen d'un laser.

8. Procédé suivant la revendication 7, dans lequel on forme la nanostructure (103, 404) de carbone sur le substrat et on forme la piste conductrice (402, 405) de carbone sur la nanostructure (103, 404) de carbone.

9. Procédé suivant la revendication 7, dans lequel on forme la piste conductrice (402, 405) de carbone sur le substrat et on forme la nanostructure (103, 404) de carbone sur la piste conductrice (402, 405) de carbone.

10. Procédé suivant la revendication 7, dans lequel on active thermiquement une activation de la piste conductrice (402, 405) de carbone dopée et/ou intercalée.

11. Procédé suivant l'une des revendications 8 à 10, dans lequel, lors de la formation de la piste conductrice (402, 405) de carbone, on forme, dans une atmosphère ayant une pression partielle d'hydrogène comprise entre 1 hectopascal et 5 hectopascal et à une température comprise entre 600° Celsius et 1000° Celsius, la piste conductrice (402, 405) de carbone en tant que couche constituée essentiellement de carbone au moyen d'un apport d'un gaz carboné.

12. Procédé suivant la revendication 11, dans lequel le gaz carboné est du méthane, de l'éthane, de la vapeur d'alcool et/ou de l'acétylène.

13. Procédé suivant l'une des revendications 11 ou 12, dans lequel la température est comprise entre 900° Celsius et 970° Celsius, la pression partielle d'hydrogène est de 1 hectopascal et, lors de la formation de la piste conductrice (402, 405) de carbone, on apporte tellement de gaz carboné, qu'il s'établit une pression totale comprise entre 500 hectopascal et 700 hectopascal.

14. Procédé suivant l'une des revendications 11 ou 12, dans lequel la température est comprise entre 750° Celsius et 850° Celsius, la pression partielle d'hydrogène est de 1,5 hectopascal et, lors de la formation de la piste conductrice (402, 405) de carbone, on apporte tellement de gaz carboné, qu'il s'établit une pression partielle du gaz carboné comprise entre 9 hectopascal et 11 hectopascal.

15. Procédé suivant l'une des revendications 11 à 14, dans lequel on maintient la température, au moins en partie, au moyen d'un chauffage photonique et/ou au moyen d'un chauffage du substrat sur une plaque chaude.

16. Procédé suivant l'une des revendications 11 à 15, dans lequel on favorise la formation de la piste conductrice (402, 405) de carbone au moyen d'un plasma de haute fréquence et/ou d'un plasma de micro-ondes.
